(19) Europäisches Patentamt / European Patent Office / Office européen des brevets

(11) **EP 2 947 471 B1**

(12) **FASCICULE DE BREVET EUROPEEN**

(45) Date de publication et mention
de la délivrance du brevet:
**11.01.2017 Bulletin 2017/02**

(51) Int Cl.:
*G01R 31/36* *(2006.01)*     *H01M 10/06* *(2006.01)*
*H01M 10/48* *(2006.01)*

(21) Numéro de dépôt: **15001495.9**

(22) Date de dépôt: **19.05.2015**

(54) **PROCÉDÉ ET DISPOSITIF DE DIAGNOSTIC D'APTITUDE À LA RÉGÉNÉRATION D'UNE BATTERIE**

VERFAHREN UND VORRICHTUNG ZUR DIAGNOSE DER REGENERATIONSFÄHIGKEIT EINER BATTERIE

METHOD AND DEVICE FOR DIAGNOSING THE REGENERATION ABILITY OF A BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.05.2014 FR 1401164**

(43) Date de publication de la demande:
**25.11.2015 Bulletin 2015/48**

(73) Titulaire: **Sustainable Development & Competitiveness**
**26500 Bourg les Valence (FR)**

(72) Inventeur: **Diedhiou, Seydina Oumar**
**26500 BOURG LES VALENCE (FR)**

(74) Mandataire: **Barbot, Willy**
**SIMODORO-ip**
**1 place des Prêcheurs**
**13100 Aix-en-Provence (FR)**

(56) Documents cités:
**DE-A1- 10 103 848**     **DE-A1-102008 056 304**
**US-A1- 2011 054 815**

• **"Professional Digital Multimeter Models", , 1 avril 2004 (2004-04-01), XP055137221, Extrait de l'Internet: URL:www.aemc.com [extrait le 2014-08-28]**
• **N Ma ET AL: "Digital Multimeters Model C.A 5210 Model C.A 5220 MULTIMETER Hz Ve lec V OF F mA 10 A C . A 5 2 2 0", , 1 janvier 2012 (2012-01-01), XP055137089, Extrait de l'Internet: URL:http://www.chauvin-arnoux.us/pdfs_aemc /user-manuals/CA5210-5220_EN.pdf [extrait le 2014-08-28]**

**EP 2 947 471 B1**

**Description**

La présente invention concerne un procédé et un dispositif de diagnostic d'aptitude à la régénération d'une batterie.

Afin de correctement orienter une batterie vers une filière de recharge, de régénération ou de recyclage, il est important de réaliser une estimation de l'état fonctionnel de cette batterie.

La recharge consiste, de manière classique, à appliquer une tension sensiblement constante pendant un temps donné afin de redonner à une batterie sa charge initiale. Le procédé de charge met principalement en jeu des relations électrochimiques réversibles et inverses de celles se produisant en décharge lors de l'utilisation de la batterie. La recharge peut typiquement être appliquée par l'utilisateur de la batterie. L'objectif est ici de redonner à une batterie des caractéristiques fonctionnelles sensiblement identiques aux caractéristiques nominales d'une batterie neuve.

La régénération comprend des procédés électriques visant à dissoudre certains dépôts cristallins, par exemple par application d'un courant pulsé à une fréquence donnée, et/ou des procédés de compensation de perte de matière, par exemple par électrodéposition.

Les procédés de régénération mettent principalement en jeu des relations dites irréversibles, en ce qu'elles ne sont pas inversées par la simple recharge. La régénération nécessite typiquement une infrastructure plus conséquente que la recharge. L'objectif est ici encore de redonner à une batterie des caractéristiques fonctionnelles sensiblement identiques aux caractéristiques nominales d'une batterie neuve.

Enfin, lorsque ni la recharge, ni la régénération ne sont susceptibles de redonner à une batterie des caractéristiques fonctionnelles sensiblement nominales, il convient de procéder à son recyclage. Ce recyclage correspond à la destruction de la batterie pour en extraire les matériaux et constituants de base, qui pourront ensuite être réutilisées.

Pour estimer l'état fonctionnel d'une batterie, différentes caractéristiques électriques ou chimiques peuvent être utilisées.

Une mesure de la tension à vide et/ou de la tension de service effective $U_{eff}$ d'une batterie est un indicateur de l'état de la batterie. Une comparaison avec un premier seuil, par exemple 10,2V pour une batterie de tension nominale UN de 12V, permet d'indiquer, si sa tension est supérieure, que la batterie peut encore être rechargée et, si sa tension est inférieure, qu'une recharge ne suffit pas et qu'une régénération de la batterie doit être envisagée. Une comparaison avec un deuxième seuil, par exemple de 4V pour une batterie de tension nominale UN de 12V, permet d'indiquer si la batterie peut encore être régénérée ou doit être recyclée.

Cependant un tel indicateur est par trop simpliste en ce qu'il ne tient pas compte de l'état de charge et des conditions d'utilisation (courant, température, etc.). Il ne permet pas d'avoir une indication pour une batterie de l'aptitude à tenir une charge ou encore de son historique électrochimique qui détermine l'aptitude à être régénérée.

L'état de santé ou SOH (de l'anglais State Of Health) est basé sur la capacité C d'une batterie et est défini comme le rapport de la capacité effective $C_{eff}$ à la capacité nominale $C_N$ ou initiale de la batterie. Ce rapport diminue avec le temps et le nombre de cycles d'utilisation, charge et décharge, de la batterie. Il est généralement considéré que lorsque ce rapport de capacité $C_{eff}/C_N$ devient inférieur à 80%, la batterie concernée doit être considérée comme usagée.

Un tel indicateur, même s'il constitue une meilleure image du cycle de vie et de l'état fonctionnel d'une batterie reste encore trop simpliste.

Une autre méthode d'analyse, dite du « coup de fouet » exploite une relation linéaire entre une tension de pic, une tension de plateau et une capacité C de la batterie. Le coup de fouet est un effet qui apparait uniquement au début d'une décharge d'une batterie complétement chargée. L'analyse nécessite une mesure de différence de tension réalisé en déchargeant une batterie chargée. Mais une telle méthode, du fait de la nécessitée de bénéficier d'une batterie avec une charge complète, n'est pas applicable à une batterie ne tenant pas la charge.

Alternativement ou complémentairement, il est encore possible de procéder à des analyses de l'électrolyte. Une mesure de densité de l'électrolyte est ainsi indicative de la composition chimique. Une densité effective $d_{eff}$, pour un électrolyte $H_2SO_4$ dilué, au moins égale à 1,21g/cm$^3$, est classiquement considérée pour qu'une batterie soit apte à la régénération. Un critère additionnel de variation ne dépassant pas un seuil donné, par exemple 0,04g/cm$^3$, entre les éventuelles cellules multiples de la batterie, peut être ajouté. La densité nominale $d_N$ d'un tel électrolyte $H_2SO_4$ dilué est supérieure ou égale à 1,26g/cm$^3$.

Maintenant, une mesure de densité de l'électrolyte est dommageable à plusieurs titres. Typiquement réalisée manuellement à l'aide d'un pèse-acide, elle nécessite d'accéder aux différentes cellules de la batterie, typiquement au nombre de 6, et ainsi une ouverture et une fermeture de chacune des cellules. L'opération complète qui peut durer de 5 à 8 mn est longue et ne permet de tester que 8 à 12 batteries par heure. De plus l'accès à l'électrolyte, acide sulfurique $H_2SO_4$ dilué, crée un risque d'exposition de l'opérateur à la corrosion et un risque d'exposition de l'environnement à la pollution. Un autre inconvénient d'une mesure de densité de l'électrolyte est qu'elle n'est applicable ni aux batteries dont l'électrolyte est sous forme de gel ni aux batteries dites sans entretien où l'électrolyte, contenu dans un réservoir étanche, n'est pas accessible.

De manière pragmatique et économique, un inconvénient majeur de ces approches est leur fiabilité. Un procédé de sélection combinant les seuils de tension et les seuils de densité précédents conduit à conserver et à présenter au procédé de régénération des batteries dont seulement 20 à 30% recouvrent une santé nominale apte à un nouvel emploi. US2011/0054815, DE10103848, DE102008056304 divulgue des procédés de diagnostic des batteries.

Un procédé de diagnostic d'aptitude à la régénération d'une batterie, ne présentant pas les inconvénients précités, est donc vivement recherché.

L'invention a pour objet un procédé de diagnostic d'aptitude à la régénération d'une batterie de type plomb-acide en conformité avec la revendication 1 comprenant la soumission de cette batterie aux trois tests suivants :

a) un test de l'électrolyte vérifiant que la quantité de sulfate de plomb effective ($m_{PbSO4eff}$) dans l'électrolyte de cette batterie est inférieure à la quantité de sulfate de plomb seuil de régénérabilité ($M_{PbSO4}$),
b) un test de la matière active, vérifiant que la quantité d'oxyde de plomb effective ($m_{PbO2eff}$) dans l'électrolyte de cette batterie est supérieure à la quantité d'oxyde de plomb seuil de régénérabilité ($m_{PbO2R}$),
c) un test des électrodes, vérifiant que la corrosion des électrodes est inférieure à une corrosion seuil ;
chacun de ces tests étant effectué sans avoir à accéder à l'une quelconque de l'électrolyte des cellules de cette batterie, et le ou les résultats à ces tests étant utilisé pour poser un diagnostic d'aptitude à la régénération pour cette batterie de type plomb-acide.

Les trois tests sont réalisés dans l'ordre.

On pourra soit réaliser le test suivant si le test précédent s'est révélé positif ou alors réaliser systématiquement les trois tests consécutivement. Maintenant, la batterie sera mise au rebut ou recyclée dès lors qu'un seuil à l'un de ces trois tests a été dépassé.

En lien avec le test de l'électrolyte, la quantité de sulfate de plomb effective ($m_{pbSO4eff}$) dans la batterie est estimée au regard de sa tension effective ($U_{eff}$) et/ou de sa résistance effective ($R_{eff}$). On préférera toutefois utiliser la résistance effective ($R_{eff}$) de cette batterie pour estimer la quantité de sulfate de plomb effective ($m_{PbSO4eff}$) dans l'électrolyte de ses cellules.

En lien avec cette résistance effective ($R_{eff}$), la quantité de sulfate de plomb effective ($m_{PbSO4eff}$) dans l'électrolyte des cellules de cette batterie est considérée comme inférieure à la quantité seuil de sulfate de plomb de régénération ($m_{PbSO4}$) (la batterie ne satisfaisant pas alors au test de l'électrolyte), dès lors que sa résistance effective ($R_{eff}$) est supérieure à 53,2 m$\Omega$ pour une batterie à plaques minces (VU et VL), ou à 56 m$\Omega$ pour une batterie à plaques épaisses (PL).

A l'heure actuelle, il n'existe pas de solutions techniques conçues pour mesurer à proprement parlé la résistance effective sans opérer au préalable une décharge profonde de la batterie jusqu'à sa tension seuil de régénérabilité $U_R$. La profondeur et la brutalité d'une telle décharge provoquerait un décollement de la matière active et par conséquence l'inaptitude à la régénération de la batterie.

Dans un mode de réalisation non automatisé, la résistance effective peut être mesurée aux bornes de la batterie avec un multimètre ayant une impédance d'entrée au moins égale à 10 mégohms (m$\Omega$) et constitué d'un circuit intégré NJU5210. Ce type d'appareil est disponible dans le commerce, mais n'est pas prévu pour la mesure de résistance sur un circuit sous tension (cas des batteries). Toutefois, on peut mesurer la résistance effective($R_{eff}$) en modifiant les composants R7, R8 et R14 (R7=1,2K$\Omega$ ; R8=220$\Omega$ ; R14=430K$\Omega$) du multimètre et en procédant comme suit :

- brancher le multimètre aux bornes de la batterie à contrôler en respectant la polarité,

- Placer le commutateur sur la fonction ohmmètre $\Omega$ du multimètre,

- Sélectionner le mode courant continu et le calibre mégohm M$\Omega$,

- lancer la mesure.

- La valeur de la résistance effective ce stabilise dans les secondes qui suivent le lancement de la mesure.

- Corriger le calibre en multipliant la valeur de résistance effective ($R_{eff}$) affichée en ohms par $10^{-3}$.

Ainsi, la valeur corrigée correspond à la résistance effective de la batterie exprimée en milliOhms (m$\Omega$).

Pour le test de la matière active, la quantité d'oxyde de plomb effective ($m_{pbO2eff}$) dans les électrolytes de cette même batterie peut elle être estimée à l'aide de différents paramètres comme sa tension effective ($U_{eff}$), sa résistance effective ($R_{eff}$), sa capacité effective ($C_{eff}$), son courant de décharge effectif ($I_{eff}$), ou encore de son courant crête effectif ($CCA_{eff}$).

Pour cette estimation, notre préférence ira cette fois à la mesure de son courant crête effectif, la quantité d'oxyde de plomb effective ($m_{pbO2eff}$) dans les électrolytes de cette batterie étant alors considérée comme supérieure à la quantité seuil d'oxyde de plomb de régénération ($m_{PbO2R}$), et la batterie étant considérée comme pouvant être potentiellement régénérée, dès lors que son courant crête effectif ($CCA_{eff}$) est supérieure à 200 A.

Dans un mode de réalisation non automatisé, le $CCA_{eff}$ est mesuré au moyen d'un testeur de charge de batterie disponible dans le commerce. Cependant, il est conseillé de privilégier les modèles numériques aux modèles analogues mettant en oeuvre des courants de décharge importants (plus de 10A) et pouvant, de ce fait, ne pas fonctionner lorsque la batterie est très déchargée (cas des batteries usagées). Pour mesurer le $CCA_{eff}$, il faut raccorder le testeur de charge aux bornes de la batterie à contrôler, tout en respectant la polarité. Sélectionner la norme de référence à utiliser (SAE / DIN / EN / JIS ...). Enter la valeur du courant crête nominale $CCA_N$ indiquée sur la batterie et lancer le test. La valeur du $CCA_{eff}$ est donnée en Ampère dans les secondes qui suivent le lancement du test.

Enfin, et pour le test des électrodes, leur état de corrosion pourra elle être estimé par la mesure de la conductance effective ($G_{eff}$) ou du courant de circuit effectif ($Ic_{eff}$) de la batterie.

En lien avec le courant de circuit effectif ($Ic_{eff}$), l'état de corrosion des électrodes sera considéré comme satisfaisant dès lors que le courant de circuit effectif ($Ic_{eff}$) de cette batterie sera supérieure à 193 A pour une batterie à plaques minces (VU et VL), ou à 172 A pour une batterie à plaques épaisses (PL).

A l'instar de la résistance effective, il n'existe pas de solutions techniques prêtes à l'emploi pour mesurer la conductance effective ($G_{eff}$) ou le courant de circuit effectif ($Ic_{eff}$) d'une la batterie. Toutefois, le courant de circuit effectif ($Ic_{eff}$) peut être déterminé à la suite de la mesure de la tension effective $U_{eff}$ (V) et de la résistance effective $R_{eff}$ ($\Omega$) aux bornes de la batterie par l'instrumentation et le protocole décrit précédemment. $Ic_{eff}$ est donnée par le rapport : $U_{eff}/ R_{eff}$

Par simplification, on jugera l'état de corrosion des électrodes satisfaisant dès lors que son courant de circuit effectif ($Ic_{eff}$) sera supérieure à 193 A pour une batterie 12V qu'elle présente des plaques minces (VU et VL), ou des plaques épaisses (PL).

On peut imaginer aussi adjoindre simplement à notre procédé une étape de détermination des caractéristiques nominales de la batterie et une étape de calcul des différents seuils, au moyen des différents modèles décrits par la suite.

On pourra aussi adjoindre et assez simplement au procédé selon l'invention, une étape de contrôle de l'aspect de la batterie.

D'autres caractéristiques, détails et avantages de l'invention ressortiront plus clairement de la description détaillée qui est faite ci-après à titre indicatif en relation avec des dessins sur lesquels :

- les figures 1 et 3 présentent un modèle figurant la résistance en fonction de la tension,

- la figure 2 présente un modèle figurant la tension en fonction de la densité de l'électrolyte,

- la figure 4 présente un modèle figurant le rapport de la quantité de sulfate de plomb, $PbSO_4$, à la résistance, en fonction de la tension,

- la figure 5 présente un modèle figurant le rapport de la quantité d'oxyde de plomb, $PbO_2$, à la résistance, en fonction de la tension,

- la figure 6 présente un modèle figurant la conductance en fonction de la tension,

- la figure 7 présente un modèle figurant le courant crête en fonction de la tension,

- la figure 8 présente un tableau de batteries illustratives avec leurs caractéristiques nominales et effectives et les résultats des tests en application du procédé.

Définition des variables utilisées :

U désigne une tension électrique et est exprimée en volts, V.

I désigne génériquement un courant électrique, plus particulièrement un courant de décharge, et est exprimé en ampères, A.

Ic désigne un courant de circuit et est exprimé en A.

CCA désigne un courant crête et est exprimé en A.

R désigne une résistance et est exprimée en Ohms, $\Omega$, ou milliOhms, $m\Omega$.

G désigne une conductance et est exprimée en Ohms$^{-1}$.

C désigne une capacité de charge et est exprimée en ampères heures, Ah.

t désigne un temps, en secondes, s.

d désigne une densité, en g/cm$^3$.

m désigne une masse en g.

n désigne un nombre de moles.

M désigne une masse molaire en g.

V désigne un volume en cm$^3$.

Une variable X est avantageusement précisée par l'ajout d'un indice :

$X_N$ indique une valeur nominale de la variable X, correspondant à l'état neuf initial.

$X_{eff}$ indique une valeur effective, correspondant à l'état actuel, tel que mesurable.

$X_R$ indique une valeur seuil de régénérabilité.

$X_{RPM}$ indique la valeur seuil de régénérabilité pour une batterie à plaques minces.

$X_{RPE}$ indique la valeur seuil de régénérabilité pour une batterie à plaques épaisses.

$X_p$ indique une valeur relative de la résistance potentielle à une décharge ou une charge jusqu'à la tension seuil de régénérabilité.

$X_a$ indique une valeur relative à l'électrolyte.

$X_b$ indique une valeur relative à la batterie.

$X_{PbSO4}$ indique une valeur relative au sulfate de plomb.

$X_{PbO2}$ indique une valeur relative à l'oxyde de plomb.

$X_{H2SO4}$ indique une valeur relative à l'acide sulfurique.

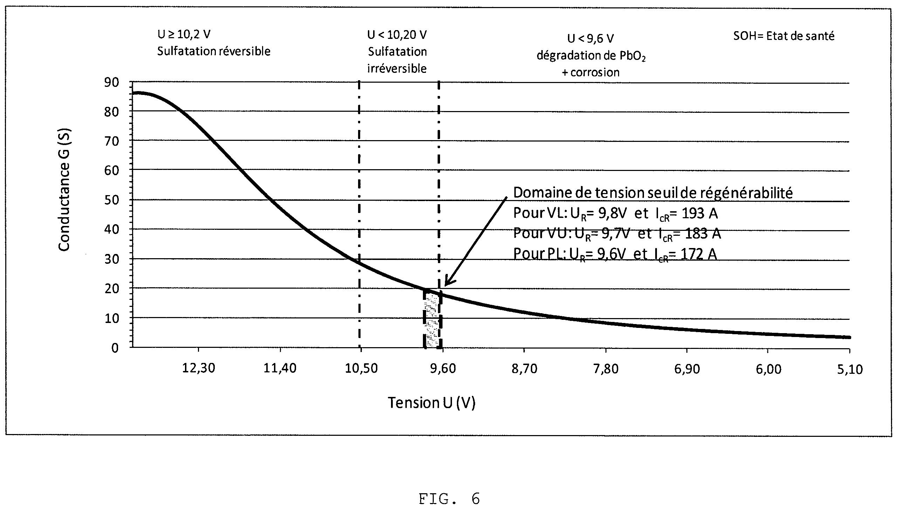

Il est considéré, dans les différents modèles qui vont être détaillés plus avant, que l'état fonctionnel d'une batterie évolue, dans le sens d'une dégradation croissante, depuis un état nominal où la batterie est opérationnelle et complètement chargée, vers plusieurs états successifs. A titre d'illustration de cette évolution, on pourra se référer à la figure 6.

Un premier état est dit « réversible » ou de « transformation réversible ». Dans ce premier état, une transformation de l'électrolyte a débuté, mais ce phénomène reste réversible et une recharge de la batterie est suffisante pour améliorer l'état fonctionnel jusqu'à retrouver un état sensiblement identique à l'état nominal.

La dégradation de l'état fonctionnel se poursuivant un deuxième état, dit « irréversible » est atteint. Dans ce deuxième état au moins trois phénomènes se produisent. D'abord, la transformation de l'électrolyte se poursuit. Ainsi, dans le cas d'une batterie plomb-acide, la transformation/sulfatation se poursuit et continue de produire du sulfate de plomb $PbSO_4$, mais ce dernier, avec le temps passe d'une forme soluble, autorisant une inversion de la réaction, à une forme cristalline, plus stable, rendant la réaction « irréversible ».

Ensuite, la dégradation de l'état fonctionnel se poursuivant, il apparait encore une dégradation de la matière active, l'oxyde de plomb $PbO_2$, dont la masse se réduit progressivement.

Enfin, la dégradation de l'état fonctionnel se poursuivant, une corrosion des électrodes se produit. Ces trois phénomènes sont dits « irréversibles ».

Pour le premier phénomène, il est cependant possible, au moyen d'un procédé de régénération, par exemple au moyen d'un courant pulsé, de retransformer le sulfate de plomb y compris depuis la forme cristalline. Il convient cependant de vérifier qu'un seuil de régénérabilité de l'électrolyte, par exemple sous forme d'une quantité de sulfate de plomb $m_{PbSO4}$ maximale, n'a pas été dépassé.

Pour le deuxième phénomène, il est possible, au moins partiellement, par un procédé d'électrodéposition de recharger la matière active afin de restaurer sa quantité. Il convient cependant de vérifier qu'un seuil de régénérabilité de la matière active, par exemple sous forme d'une quantité d'oxyde de plomb $m_{PbO2}$ minimale, n'a pas été dépassé.

Pour le troisième phénomène, seul réellement irréversible, il n'existe pas de moyen curatif connu. Cependant il convient de vérifier qu'une corrosion trop importante, de nature à entraver le bon fonctionnement de la batterie, n'a pas été atteinte.

Tant qu'aucun de ces trois seuils n'est atteint, la batterie se trouve dans le deuxième état, et peut donc potentiellement être régénérée afin de corriger soit l'état de transformation de l'électrolyte, soit la quantité de matière active.

Maintenant, dès qu'un des trois seuils est atteint, la batterie passe dans le troisième état. Elle n'est alors plus régénérable et le plus simple est de la rebuter ou mieux de la recycler.

Aussi, un procédé de diagnostic d'aptitude à la régénération d'une batterie comprend au moins un test parmi trois tests permettant chacun de vérifier chacun de ces trois phénomènes. Avantageusement les trois tests sont réalisés conjointement et le ou les résultats sont considérés pour poser un diagnostic d'aptitude à la régénération pour cette batterie.

De plus, ces trois tests correspondant à une progression de la dégradation de l'état fonctionnel, il est de bonne économie de les appliquer dans l'ordre, en ne réalisant un test suivant que si le test précédent est positif.

Un premier test concerne l'électrolyte. Il s'agit ici de vérifier que l'état de l'électrolyte est apte à être régénéré, ou même simplement rechargé. Pour cela un degré de transformation, est estimé et comparé à une valeur de transformation seuil majorant de régénérabilité.

Un deuxième test concerne la matière active et a pour but de vérifier que la quantité de matière active résiduelle est supérieure à une quantité de matière active, considérée comme seuil de régénérabilité.

Un troisième test concerne les électrodes. Ce test a pour but de vérifier que la corrosion des électrodes est inférieure à un seuil de corrosion critique.

Le premier test ou test de l'électrolyte, vérifie l'état de l'électrolyte et son aptitude à être régénéré. L'objectif est de vérifier que le degré de transformation, lié à la décharge de la batterie, n'est pas trop avancé. Un indicateur de l'état de transformation de l'électrolyte est le plus souvent une quantité d'un composant chimique dans l'électrolyte.

Pour le cas particulier d'une batterie plomb-acide, les équations chimiques sont les suivantes.

A l'électrode positive:

$$PbO_2 + HSO_4^- + 3H_3O^+ + 2e^- <-> PbSO_4 + 5H_2O$$

$$PbO_2 + SO_4^{2-} + 4H_3O^+ + 2e^- <-> PbSO_4 + 6H_2O$$

A l'électrode négative:

$$Pb + HSO_4^- + H_2O <-> PbSO_4 + 6H_2O + H_3O^+ + 2e^-$$

$$Pb + SO_4^{2-} <-> PbSO_4 + 2e^-$$

La transformation est ici une sulfatation (du plomb) et le composant chimique indicatif du degré de transformation ou degré de sulfatation de l'électrolyte peut avantageusement être le sulfate de plomb, $PbSO_4$.

Le test de l'électrolyte va donc consister à vérifier qu'une quantité de sulfate de plomb effective, $m_{PbSO4eff}$, est inférieure à une quantité de sulfate de plomb seuil de régénérabilité, $m_{PbSo4R}$, prise comme seuil. Il est considéré que tant que la quantité/masse/concentration de sulfate de plomb reste inférieure au seuil, la transformation de l'électrolyte n'est pas trop avancée et il reste possible de revenir à un état nominal par un procédé de régénération. Le résultat du test de l'électrolyte est alors positif. A défaut, l'électrolyte ne peut être régénéré, le résultat du test est négatif et la batterie est dirigée préférentiellement vers le rebut ou le recyclage.

Sachant que le procédé selon l'invention vise à permettre un diagnostic automatisé et le plus rapide possible, l'estimation de la valeur effective $m_{PbSO4eff}$ de la quantité de sulfate de plomb par sa mesure directe est à proscrire. De même, la mesure indirecte de cette valeur en déterminant la densité $d_{H2SO4}$, de l'électrolyte $H_2SO_4$, est elle aussi à proscrire dans la mesure où elle nécessite elle aussi d'accéder à l'électrolyte de la batterie.

Le procédé selon l'invention utilise donc un moyen alternatif, uniquement « électrique », pour obtenir une estimation de la quantité effective $m_{PbSO4eff}$ de sulfate de plomb ou de la densité effective $d_{eff}$ de l'électrolyte.

En lien avec la densité $d_{H2SO4}$, de l'électrolyte $H_2SO_4$, plus simplement notée d. Celle-ci évolue entre sa valeur nominale $d_N$ et sa valeur effective $d_{eff}$. La masse effective $m_{PbSO4eff}$ de sulfate de plomb est calculée simplement à partir de ces valeurs de densité par la formule $m_{PbSO4eff} = (d_N-d_{eff}) *M_{PbSO4}/M_{H2SO4}$, où $M_X$ désigne la masse molaire du composé X. La densité nominale $d_N$ est connue, égale à 1.28g/cm$^3$ pour un électrolyte acide sulfurique dilué $H_2SO_4$, les masses molaires $M_{PbSO4}$ et $M_{H2SO4}$ sont connues, $M_{PbSO4}$ = 303,26g et $M_{H2SO4}$ = 98,079g, aussi la densité effective $d_{eff}$, mesurée ou estimée, permet de connaitre la quantité effective $m_{PbSO4eff}$ de sulfate de plomb.

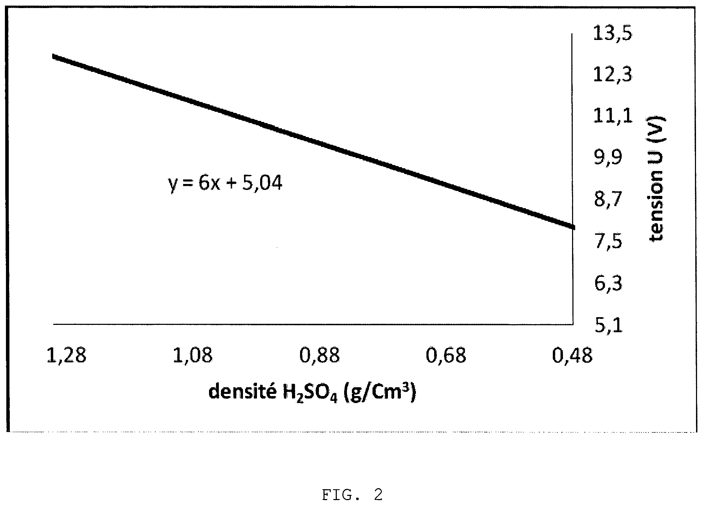

Un premier moyen consiste à utiliser une modélisation, telle qu'illustrée à la figure 2, de la tension effective $U_{eff}$ de la batterie en fonction de la densité effective $d_{eff}$ de l'électrolyte. Une modélisation affine, d'une batterie de tension nominale UN = 12V, donne :

$$U = 6d + 5,04$$

(pour une cellule électrochimique de tension nominale $U_N$ = 2V, on a donc U = d + 0,84), ce qui permet d'estimer la densité effective $d_{eff}$ de l'électrolyte à partir d'une mesure de la tension effective $U_{eff}$ de la batterie. A partir de cette densité effective $d_{eff}$ de l'électrolyte, il est possible de déterminer la quantité effective $m_{PbSO4eff}$ de sulfate de plomb, comme décrit précédemment.

Dans ce cas, on peut donc accéder à la masse effective $m_{PbSO4eff}$ de sulfate de plomb en résolvant les deux équations suivantes :

$$U_{eff} = 6d_{eff} + 5,04 \quad et$$

$$m_{PbSO4eff} = (1,28-d_{eff}) * 303,26/98,079$$

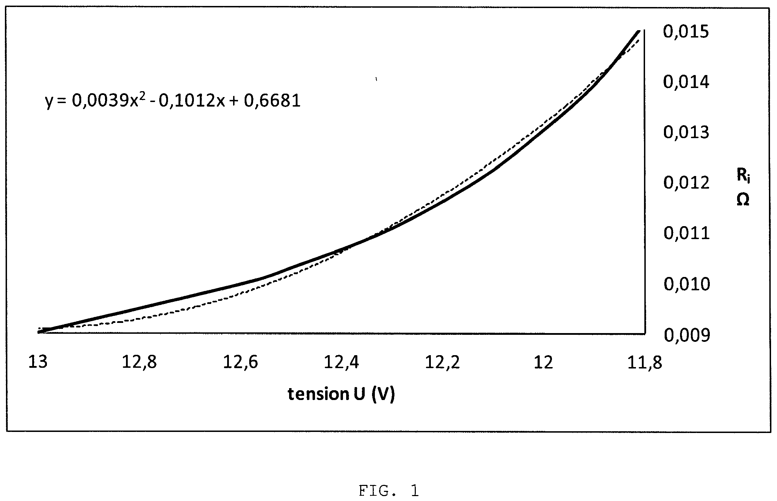

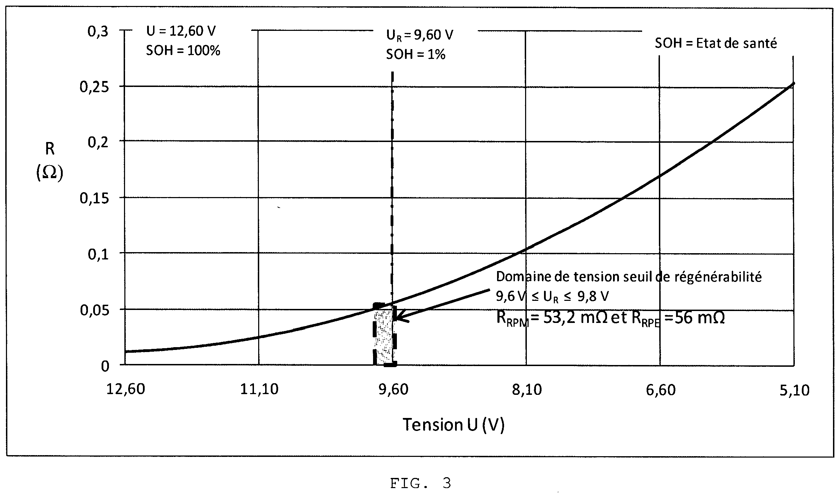

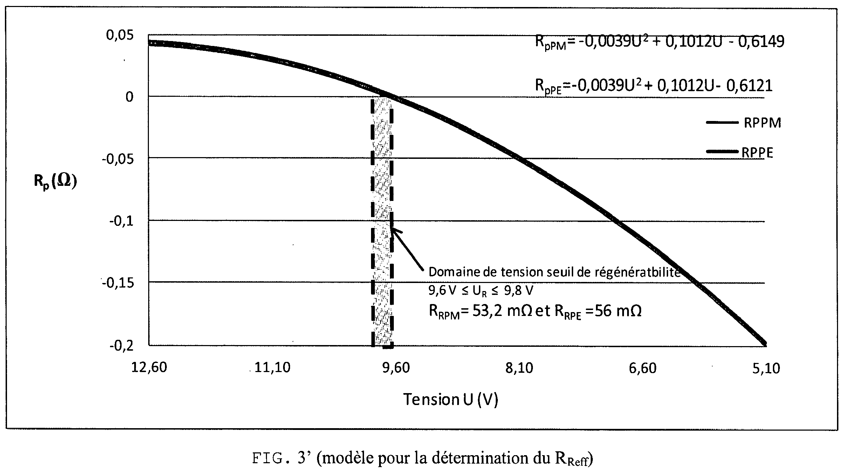

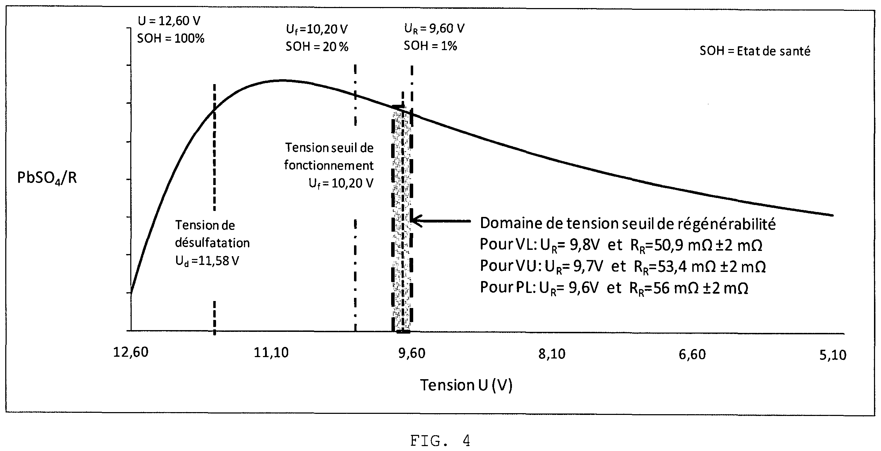

Un autre moyen consiste à modéliser la variation du rapport de la quantité de sulfate de plomb $m_{PbSO4}$ sur la résistance R, en fonction de la tension U de la batterie. Un exemple d'un tel modèle est illustré à la figure 4. Ce modèle est construit à partir du modèle de la résistance interne $R_i$ en fonction de la tension U, dont un exemple est illustré à la figure 1. Le modèle de la figure 1 est utilisé, notamment en le prolongeant, pour déterminer une résistance R, y compris dans le domaine des tensions caractéristiques d'une batterie déchargée. Ceci est illustré à la figure 3. Sur le modèle de la figure 4 sont figurées différentes tensions U caractéristiques. Par valeur décroissante, la tension de désulfatation $U_d$ marque le début de la réaction chimique de désulfatation lors de la charge et la formation de sulfate de plomb $PbSO_4$ qui s'accumule et cristallise lors de la décharge. Pour une batterie de tension nominale $U_N$ = 12V, la tension de désulfatation $U_d$ est égale à 11,58V. Vient ensuite la tension seuil de fonctionnement $U_f$, généralement admise comme limite de décharge avec nécessitée de recharge. Pour une batterie de tension nominale $U_N$ = 12V, la tension de seuil de fonctionnement $U_f$ est égale à 10,2V. Enfin, on trouve une tension seuil de régénérabilité $U_R$, seuil en dessous de laquelle une batterie n'est pas régénérable, on parle alors de tension seuil de régénérabilité. Pour une batterie de tension nominale $U_N$ = 12V, la tension seuil de régénérabilité dépend de la catégorie de batterie. Dans le cas particulier des batteries de démarrage, il est commun de distinguer trois catégories de batteries, les batteries utilisées pour le démarrage de véhicules légers notées VL, celles utilisées pour les véhicules utilitaire notées VU et celles utilisées pour les véhicules poids lourds notées PL. Une batterie VL présente une tension seuil de régénérabilité $U_R$ égale à 9,8V, une batterie VU présente une tension seuil de régénérabilité $U_R$ égale à 9,7V, sont constituées de plaques de faible épaisseur, alors qu'une batterie PL présente une tension seuil de régénérabilité $U_R$ égale à 9,6V.

Sur l'intervalle de tension U compris entre la tension de désulfatation $U_d$ et la tension seuil de régénérabilité $U_R$, la variation de la résistance R de la batterie est principalement due à l'accumulation de sulfate de plomb $PbSO_4$ et à sa transformation progressive avec le temps d'une forme soluble vers une forme cristalline. Ainsi, la résistance R d'une batterie dont la tension U est différente de la tension seuil de régénérabilité $U_R$ est l'expression de la somme de la résistance interne $R_i$ de la batterie et de la résistance potentielle $R_p$ à une décharge ou une charge jusqu'à la tension seuil de régénérabilité

$$U_R, \quad d'où \quad R = R_p + R_i.$$

La résistance potentielle $R_p$ peut être mesurée ou estimée à partir des modèles de la figure 3' qui indique la relation entre la résistance $R_p$ et la tension U selon le type de batterie, avec, pour une batterie de type PM, $R_p$= -0,0039U$^2$ + 0,1012U - 0,6149 et pour une batterie de type PE, $R_p$= - 0,0039U$^2$ + 0,1012U- 0,6121.

La résistance interne $R_i$ peut être estimée à partir du modèle de la figure 1 ou mesurée consécutivement à une perturbation apportée à la batterie sous forme de créneau. Le terme impédance interne Z est employé lorsque la perturbation utilisée est sous forme sinusoïdale. A toutes fins utiles, les équations suivantes peuvent servir pour déterminer la résistance interne $R_i$ ou l'impédance interne Z :

$$R_i = \frac{\Delta U}{I} \quad \text{ou} \quad [Z] = \frac{[E]}{[I]}$$, avec $\Delta U$ la variation de la tension sur une période de charge ou de la décharge de la batterie, I l'intensité du courant en ampère A ayant servi à apporter la perturbation sous forme de charge ou de décharge.

[Z] le module de l'impédance interne en Ohms, [E] le module de la tension alternative aux bornes de la batterie, et [I] le module du courant aux bornes de cette même batterie en Ampères.

Ces deux méthodes peuvent donc être utilisées pour déterminer la résistance interne $R_i$.

Dans un mode de réalisation avantageux, $R_i$ est estimé par une décharge égale à 2A sur une durée de 2s. La valeur de $R_{ieff}$ correspond à résistance interne à 0s calculée à partir de l'équation de la droite :

$$R_i(t) = R_{i0s} + a\sqrt{t}$$ passant par $R_{i1s}$ à t=1s et $R_{i2s}$ à t=2s avec $R_{i1s} = \frac{U_{1s} - U_{0s}}{-2}$ et $R_{i2s} = \frac{U_{2s} - U_{0s}}{-2}$,

$U_{0s}$ est la tension mesurée aux bornes de la batterie au lancement de la décharge. $U_{0s}$ est différente de la tension de circuit ouvert (en anglais open circuit voltage OCV) ou tension de repos.

Il peut être constaté, que les trois points $U_d$, $U_f$ et $U_R$ sont sensiblement alignés sur la courbe de la figure 4. Aussi sur l'intervalle compris entre la tension de désulfatation $U_d$ et la tension seuil de régénérabilité $U_R$, le rapport de la quantité de sulfate de plomb $m_{PbSO4}$ sur la résistance R est sensiblement constant, aussi la résistance effective $R_{eff}$ y est directement proportionnelle à la quantité de sulfate de plomb $m_{PbSO4eff}$. La mesure de la résistance effective permet une estimation de la quantité effective de sulfate de plomb $m_{PbSO4eff}$. La résistance effective est estimée à partir de l'équation définie précédemment. Ainsi, la résistance effective $R_{eff}$ est estimée par simple mesure de la résistance interne $R_i$, de la tension U de la batterie, et application de la formule :

Pour une batterie type PM (VL et VU):

$$R_{eff} = R_{ieff} - 0,0039U^2_{eff} + 0,1012U_{eff} - 0,6149$$

Pour une batterie type PE (PL):

$$R_{eff} = R_{i0eff} - 0,0039U^2_{eff} + 0,1012U_{eff} - 0,6121$$

A partir de la tension seuil de régénérabilité $U_R$ déterminée pour une batterie, le modèle de la figure 3 qui indique la relation entre la résistance R et la tension U, avec une formule analytique R = $0,0039U^2-0,1012U+0,6681$, permet de déterminer une résistance seuil de régénérabilité $R_R$ apte à être comparée à une résistance effective $R_{eff}$.

Au regard de ces éléments, l'inventeur a pu déterminer que pour une batterie de tension nominale $U_N$ = 12V, la résistance seuil de régénérabilité $R_R$ pour une batterie VL dont la tension seuil de régénérabilité est égale à 9,8V, présente une valeur de 50,9 m$\Omega$ ± 0,2 m$\Omega$, soit au minimum 50,7 m$\Omega$, une batterie VU dont la tension seuil de régénérabilité est égale à 9,7V présente une valeur de 53,4 m$\Omega$ ±0,2 m$\Omega$ soit au minimum 53,2 m$\Omega$ et une batterie PL dont la tension seuil de régénérabilité $U_R$ est égale à 9,6V présente une valeur de 56 m$\Omega$ ±0,2 m$\Omega$ soit au minimum 55,8 m$\Omega$. Dans un mode de réalisation préférentiel, pour simplifier le procédé de diagnostic et atteindre un niveau de fiabilité maximale, il est avantageusement convenu d'utiliser une résistance seuil de régénérabilité $R_R$ selon le type de plaques et la valeur la plus contraignante. Les batteries VL et les batteries VU sont constitués de plaques biens moins épaisses que celles des batteries PL. Sur la base de ce critère, les batteries VL et les batteries VU sont dites de type plaques minces PM, tandis que les batteries PL sont dites de type plaques épaisses PE. Ainsi, pour les batteries à plaques minces (batteries VL et VU), la valeur de la résistance seuil de régénérabilité notée $R_{RPM}$ à considérer est égale à 53,2 m$\Omega$. Pour les batteries à plaques épaisses PE), on considère avantageusement que la valeur de la résistance seuil de régénérabilité notée $R_{RPE}$ est égale à 56 m$\Omega$.

La tension seuil de régénérabilité $U_R$, et donc la résistance seuil de régénérabilité $R_R$, est indicative de la quantité de sulfate de plomb à régénérer $m_{PbSO4R}$. Il s'ensuit que le test de l'électrolyte nécessite une simple mesure de la résistance effective $R_{eff}$ aux électrodes de la batterie. Cette opération est rapide et ne nécessite avantageusement pas d'accès à l'électrolyte. Cette mesure de résistance effective $R_{eff}$ est ensuite comparée à la résistance seuil de régénérabilité $R_R$ précédemment déterminée en fonction des caractéristiques nominales de la batterie. Dans le cas où le test de l'électrolyte est positif, la résistance effective $R_{eff}$ est supérieure ou égale à la résistance seuil de régénérabilité $R_R$, et la batterie est apte à la régénération.

Le deuxième test ou test de la matière active, vérifie la quantité résiduelle de matière active et son aptitude à la régénération. Ainsi pour une batterie de type plomb-acide, la matière active est de l'oxyde de plomb $PbO_2$ dont l'estimation de la quantité résiduelle permet de déterminer si une batterie est encore régénérable ou s'il ne reste plus assez de matière active. Le résultat du test de la matière active est alors positif si la quantité de matière active restante est suffisante et qu'une régénération permet de reconstituer ladite matière. A défaut, la matière active ne peut être régénérée et le résultat du test est négatif.

Afin de réaliser ce deuxième test, il convient d'une part d'estimer la valeur effective $m_{PbO2eff}$ de la quantité d'oxyde de plomb, et d'autre part de déterminer la valeur $m_{PbO2R}$ du seuil de régénérabilité, afin de pouvoir les comparer.

Un premier moyen d'obtenir une estimation de la valeur effective $m_{PbO2eff}$ de la quantité d'oxyde de plomb serait de la mesurer directement. Mais, sachant que le procédé selon l'invention vise à permettre un diagnostic automatisé et le plus rapide possible, l'estimation de la valeur effective $m_{PbO2eff}$ de la quantité d'oxyde de plomb par sa mesure directe est à proscrire. De même, la mesure indirecte de cette valeur en déterminant la densité $d_{H2SO4}$, de l'électrolyte $H_2SO_4$, est elle aussi à proscrire dans la mesure où elle nécessite elle aussi d'accéder à l'électrolyte de la batterie.

Aussi, le procédé selon l'invention utilise donc un moyen alternatif, uniquement « électrique », pour obtenir une estimation de la quantité effective $m_{PbO2eff}$ d'oxyde de plomb ou de la densité effective $d_{eff}$ de l'électrolyte.

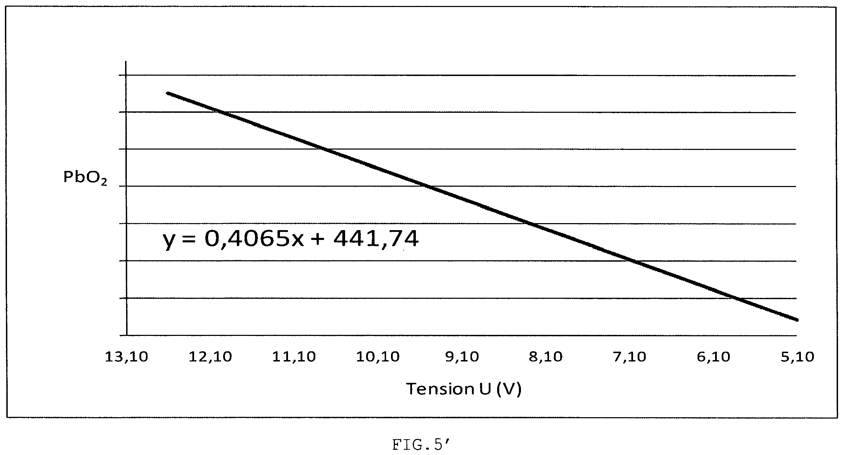

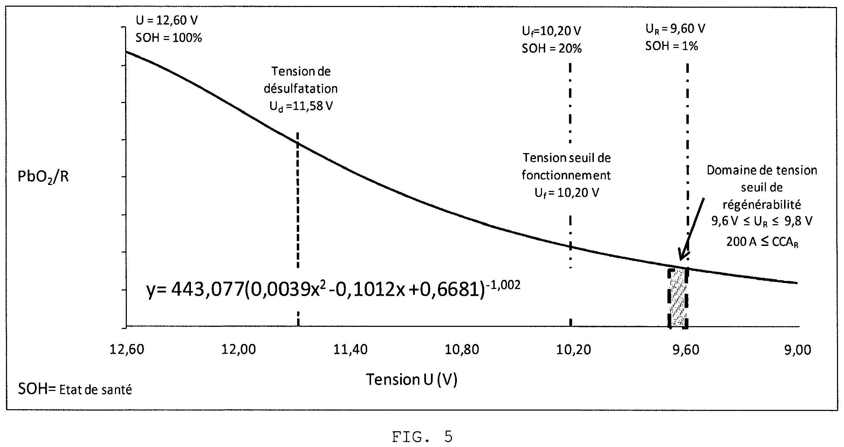

Un premier moyen consiste comme pour le sulfate de plomb, à utiliser une modélisation, telle qu'illustrée à la figure 2, de la tension effective $U_{eff}$ de la batterie en fonction de la densité effective $d_{eff}$ de l'électrolyte, ou telle qu'illustrée à la figure 5' avec la formule :

$$m_{PbO2eff} = 0,4065 U_{eff} + 441,74.$$

Un autre moyen consiste à modéliser la variation du rapport de la quantité d'oxyde de plomb $m_{PbO2}$ sur la résistance R, en fonction de la tension U de la batterie. Un exemple d'un tel modèle est illustré à la figure 5. Ce modèle est construit à partir du modèle de la résistance interne $R_i$ en fonction de la tension U, illustré à la figure 1. Le modèle de la figure 1 est utilisé, notamment en le prolongeant, pour déterminer une résistance R y compris dans le domaine des tensions caractéristiques d'une batterie déchargée. Ceci est illustré à la figure 3. Sur le modèle de la figure 5 sont figurées les différentes tensions U caractéristiques décrites précédemment. Par valeur décroissante, la tension de désulfatation $U_d$, la tension seuil de fonctionnement $U_f$, et la tension seuil de régénérabilité $U_R$. La quantité d'oxyde de plomb résiduelle est alors inversement proportionnelle à la résistance R de la batterie. Cette évolution est illustrée par le modèle $m_{PbO2}/R = f(U)$ (figure 5) qui par déduction permet d'estimer de manière indirecte la quantité d'oxyde de plomb $PbO_2$. Pour estimer la quantité de $PbO_2$ il suffit alors de mesurer la résistance R et la tension aux bornes de la batterie et d'appliquer l'équation :

$$m_{PbO2} = 443,077 R^{-0,002}$$

avec R estimé à partir de sa relation avec la mention U (figure 3).

Il est également connu que la capacité C d'une batterie se réduit progressivement avec le temps. Il est généralement admis que cela est principalement lié à la diminution de la quantité de matière active. Aussi la capacité C peut être utilisée pour estimer l'état de la matière active. Le test de la matière active peut alors comprendre une vérification que la capacité effective $C_{eff}$ de la batterie se trouve être supérieure à une valeur seuil ou, autrement exprimé, qu'un taux d'utilisation, défini par le rapport de la capacité effective $C_{eff}$ à la capacité nominale $C_N$ est supérieur à un taux d'utilisation seuil de régénérabilité. Ledit seuil de régénérabilité peut être choisi égal à toute valeur. Cependant de manière classique une valeur égale à 55% est avantageusement retenue. La capacité C d'une batterie est liée à la quantité de matière active $m_{PbO2}$ par une relation linéaire $C = C_{pb02th} * m_{PbO2}$, avec $C_{Pb02th}$ capacité théorique de l'oxyde de plomb, constante égale à 0,224 Ah.g$^{-1}$. La relation linéaire précédente peut se détailler en $C = 2 * F * m_{Pb02}/M_{PbO2}$, avec F = 26,8 Ah. Il s'en déduit que le taux d'utilisation $C_{eff}/C_N$ est égal au rapport $m_{PbO2eff}/m_{PbO2N}$ de la quantité effective d'oxyde de plomb $m_{PbO2eff}$ à la quantité nominale d'oxyde de plomb $m_{PbO2N}$. Le premier terme $m_{PbO2eff}$ de ce rapport peut être déterminé par la formule $m_{PbO2eff} = m_{PbO2N} - (d_N - d_{eff}) * M_{PbO2}/M_{H2SO4}$, décrite précédemment en fonction de la densité effective $d_{eff}$. On obtient $M_{PbO2eff}/M_{PbO2N} = [1 - (d_N - d_{eff}) * M_{PbO2}/M_{H2SO4}] / M_{PbO2N}$. La densité effective $d_{eff}$ est estimée, par exemple, par l'une des méthodes précédemment décrites : mesure ou utilisation du modèle $d_{eff} = f(U_{eff})$. Le deuxième terme de ce rapport, soit la quantité nominale d'oxyde de plomb $m_{PbO2N}$, est déterminé à partir de la capacité nominale $C_N$ de la batterie, par la relation $C = C_{PbO2th} * m_{PbO2}$ qui à l'état nominal devient $C_N =$

$C_{Pb02th}*m_{PbO2N}$ et donne $m_{PbO2N} = C_N/C_{Pb02th}$. Le rapport peut ensuite être comparé au taux d'utilisation seuil de régénérabilité. Il s'ensuit que, selon un mode de réalisation avantageux, le test de la matière active nécessite une simple mesure de la tension effective $U_{eff}$ aux électrodes de la batterie. Cette opération est rapide et ne nécessite avantageusement pas d'accès à l'électrolyte. De cette tension effective $U_{eff}$ il est déduit par l'utilisation d'un modèle une densité effective $d_{eff}$ de l'électrolyte et par le calcul une masse effective résiduelle d'oxyde de plomb $m_{PbO2eff}$. Cette dernière peut être comparée à sa valeur nominale $m_{PbO2N}$ déterminable par le calcul à partir des caractéristiques nominales de la batterie.

Selon un autre mode de réalisation, le test de matière active peut être basé sur le courant de décharge I, dont la valeur effective $I_{eff}$ est liée à la capacité effective $C_{eff}$ de la batterie par la relation $I_{eff}*t = C_{eff}$, avec t représentant le temps de décharge. Il est ainsi possible de mesurer un courant de décharge $I_{eff}$ de la batterie afin d'estimer la capacité effective $C_{eff}$. La capacité nominale $C_N$ est connue des caractéristiques nominales de la batterie. Le rapport $C_{eff}/C_N$ peut alors être calculé et comparé avec la valeur du taux d'utilisation seuil de régénérabilité.

Selon un autre mode de réalisation, le courant de décharge I est relié au courant de décharge maximale ou courant crête CCA par la relation $I = CCA/10 \times t_d$), où $t_d$ est le régime temporel de décharge de la batterie, exprimé en heures. Le CCA représente le courant que la batterie est capable de fournir pour un démarrage sur 10s à -18°C. Le $CCA_{eff}$ peut être mesuré par un test de décharge à -18°C selon spécifications des normes SAE, IEC 95-1 ou DIN EN 50342 ou par un testeur de batterie du commerce. Dans un mode de réalisation avantageux, le CCA est estimé à partir du rapport entre la chute de la tension OCV de la batterie jusqu'à la tension limite de 7,2V pour une durée de 10s et de la résistance interne $R_i$ à t= 30s de décharge $R_{i30s}$. La valeur de $R_{i30s}$ correspond à résistance interne calculée à partir de l'équation de la droite : $R_i(t) = R_{i0s} + a\sqrt{30}$ établi précédemment. Ainsi,

$$CCA_{eff} = \frac{(U_{eff} - 7,2)}{0,1 R_{i30s}},$$ $U_{eff}$ est la tension de circuit ouvert (en anglais open circuit voltage OCV) ou tension de repos. L'intensité de décharge $I_{eff}$ doit nécessairement être supérieure à 1A. Aussi, pour un régime $t_d$ égal à 20h, il résulte que le courant de décharge maximale CCA doit nécessairement être supérieur à 200A.

Finalement, cette valeur de 200A est alors utilisée comme seuil de régénérabilité $CCA_R$ auquel peut être comparé le courant de décharge maximale effectif $CCA_{eff}$.

Le troisième test ou test de la corrosion des électrodes vérifie que le degré de corrosion des électrodes de la batterie n'a pas atteint une valeur critique au-delà de laquelle, même une régénération ne peut restaurer la batterie dans un état sensiblement nominal.

Là encore, l'objectif de la présente méthode est d'accéder à cette donnée sans avoir à ouvrir la batterie de sorte de permettre l'automatisation de celle-ci.

A y regarder de plus près, on observera que la corrosion d'une électrode en modifie sa structure et sa porosité, lesquelles modifications entraîne donc une variation de la conductance G de cette électrode. La conductance G est déterminée, en fonction de la résistance R, par la relation G = 1/R. La figure 6 modélise ce phénomène et illustre l'impact de l'altération des composants de la batterie par corrosion. Le modèle de la figure 6 est utilisé comme référence pour apprécier le degré de corrosion.

Ainsi, selon un premier mode de réalisation, le test de la corrosion comprendra une comparaison de la conductance effective $G_{eff}$ de la batterie diagnostiquée avec une conductance seuil de régénérabilité $G_R$. La conductance effective $G_{eff}$ peut être mesurée, tandis que la conductance seuil de régénérabilité $G_R$ est déterminée à partir de la résistance seuil de régénérabilité $R_R$ par la relation $G_R = 1/R_R$. Pour que la batterie soit apte à la régénération, il convient que la relation $G_{eff} > G_R$ soit vérifiée. Le test de corrosion est positif, et la batterie est apte à être régénérée, si la conductance effective $G_{eff}$ est supérieure à la conductance seuil de régénérabilité $G_R$. Ce test présente l'avantage sur le précédent de renseigner sur l'existence ou non de courts-circuits rampants et/ou de perte d'isolation électrique entre les deux électrodes de la batterie.

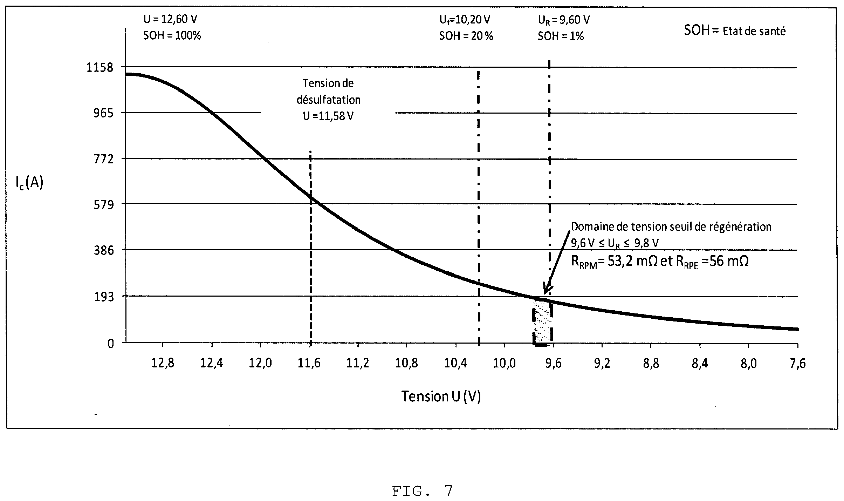

Selon un autre mode de réalisation, un courant de circuit Ic peut être utilisé pour estimer la conductivité G. En effet ces deux grandeurs sont liées par la relation Ic = U/R = U*G. L'évolution du courant de circuit Ic en fonction de la tension est modélisée à la figure 7. Il est ainsi possible de réaliser le test de la corrosion en vérifiant qu'un courant de circuit effectif $Ic_{eff}$ est supérieur à un courant de circuit seuil de régénérabilité $Ic_R$. Le courant de circuit $Ic_{eff}$ est obtenu à partir de la relation $U_{eff}/R_{eff}$ à l'issu de la mesure de $U_{eff}$ et $R_{eff}$. Le courant de circuit seuil de régénérabilité $Ic_R$ est déterminé par la formule $Ic_R = U_R/R_R$. Ainsi, par exemple, pour une batterie VL de tension nominale $U_N$=12V, la résistance seuil de régénérabilité $R_R$ est égale 50,7 mΩ et la tension seuil de régénérabilité $U_R$ est égale à 9,8V soit un courant de circuit seuil de régénérabilité $Ic_R$ de 193A. Pour une batterie VU de tension nominale $U_N$=12V, la résistance seuil de régénérabilité $R_R$ est égale 53,2 mΩ et la tension seuil de régénérabilité $U_R$ est égale à 9,7V soit un courant de circuit seuil de régénérabilité $Ic_R$ de 183A tandis qu'une batterie PL, de tension nominale $U_N$=12V, à une résistance seuil de régénérabilité $R_R$ est égale 56 m$\Omega$ et une tension seuil de régénérabilité $U_R$ est égale à 9,6V soit un courant de circuit seuil de régénérabilité $Ic_R$ de 172A.

Dans un mode de réalisation préférentiel, pour simplifier le procédé de diagnostic et atteindre un niveau de fiabilité maximale, il est avantageusement convenu d'utiliser un courant de circuit seuil de régénérabilité $Ic_R$ de 193A pour les batteries de types plaques minces (PM) et celles de types plaques épaisses.

Les différents tests précédemment décrits comparent des grandeurs effectives, $X_{eff}$, avec des grandeurs seuils de régénérabilité, $X_R$.

Une grandeur effective, $X_{eff}$, est obtenue directement par mesure, ou par calcul faisant intervenir une mesure et une ou plusieurs constantes ou une ou plusieurs grandeurs nominales.

Une grandeur seuil de régénérabilité, $X_R$, est obtenue par calcul faisant intervenir une ou plusieurs constantes ou une ou plusieurs grandeurs nominales.

Les mesures sont réalisées directement sur la batterie diagnostiquée.

Pour les grandeurs nominales, le procédé comprend une étape de détermination des grandeurs nominales de la batterie diagnostiquée. Plusieurs modes de réalisation sont ici possibles, notamment dans le cadre d'un procédé partiellement ou totalement automatisé.

Les grandeurs nominales sont généralement fournies par le constructeur de la batterie. Selon un premier mode de réalisation une batterie est identifiée dans une étape de référencement, par un identifiant, un code, une référence, un numéro de type, etc.

A cet identifiant est associé une fiche, un enregistrement, contenant toutes les grandeurs nominales attachées à cette batterie. Ainsi, par exemple, une fiche indique qu'une batterie avec un code 3 présente une tension nominale UN de 12V, une capacité nominale $C_N$ de 220 Ah, et un courant crête nominal $CCA_N$ de 1400A. La connaissance du code renseigne ainsi toutes les grandeurs nominales.

Une telle étape d'identification peut consister en une saisie manuelle d'un code par un opérateur, d'une lecture manuelle ou automatique d'un numéro de type, d'un code barre inscrit sur la batterie ou encore d'une étiquette RFID disposé sur la batterie ou de tout autre moyen d'identification possible.

Alternativement, si une identification n'est pas réalisée ou n'est pas possible, du fait par exemple d'une étiquette illisible ou absente, les grandeurs nominales peuvent, y compris dans le cadre d'un procédé automatisé, être estimées.

Ainsi la tension nominale UN peut être estimée en tenant compte d'une mesure de tension effective $U_{eff}$ et des calibres de tension nominale existants. En considérant les calibres de 6V, 12V et 24V, une tension effective $U_{eff}$ de 5V ou de 6,5V a de fortes probabilités de correspondre à une batterie de tension nominale UN de 6V, tandis qu'une tension effective $U_{eff}$ de 9V ou de 13V a de forte probabilité de correspondre à une batterie de tension nominale UN de 12V.

De même la capacité nominale $C_N$ d'une batterie non identifiée peut être calculée à partir du volume $V_a$ d'électrolyte au moyen d'un facteur de proportionnalité. Le volume d'électrolyte $V_a$ peut être estimé en fonction d'un niveau d'électrolyte, mesuré par un moyen de mesure non intrusif, tel que par exemple ultrason, thermométrie, et rapporté, le cas échéant via un facteur de corrélation au volume et/ou au poids de la batterie, mesurés ou estimés sur la batterie, avantageusement de manière automatique. Alternativement la capacité nominale $C_N$ peut être estimée directement à partir du volume $V_b$ de la batterie et/ou du poids. Ainsi une loi empirique telle que $C_N = -5.10^{-12}V_b^3 + 10^{-7}V_b^2 + 82.10^{-4}V_b - 8{,}738$, valable pour un volume $V_b$ inférieur à 30000 cm$^3$ et $C_N = 225$ Ah pour un volume $V_b$ supérieur permet d'estimer $C_N$.

A partir des données nominales, les valeurs seuil de régénérabilité peuvent être calculées.

Le procédé, y compris dans une version automatisée, peut avantageusement comprendre une inspection visuelle de la batterie. Une telle inspection, réalisée par un opérateur ou par exemple par un système d'imagerie (analyse d'image, ultrason, etc.) a pour but de réaliser un contrôle d'aspect en vue de détecter des défauts tels que déformation, fissure, fuite d'électrolyte, etc., conduisant, le plus souvent, au rebut de la batterie.

Avantageusement, le procédé précédent est implanté sur un dispositif comprenant des moyens aptes à la mise en oeuvre de tout ou partie des étapes. De manière optimale le dispositif, comprend une unité de commande et est apte à réaliser la totalité du procédé, jusqu'au diagnostic y compris, de manière totalement automatique. Une batterie peut ainsi être réceptionnée, identifiée, mesurée, diagnostiquée et orientée en conséquence, en un temps très court, de l'ordre de quelques secondes à quelques dizaines de secondes.

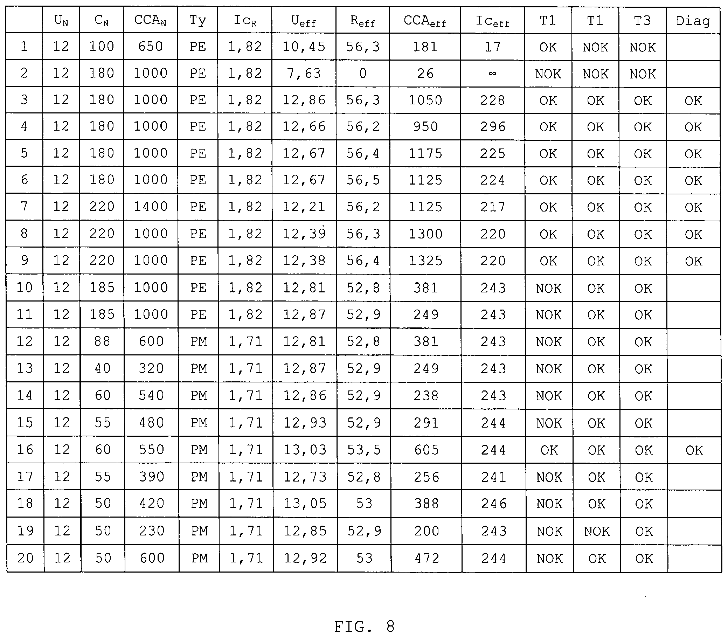

La figure 8 présente un tableau de valeurs représentant un échantillon de batteries soumises au procédé selon l'invention, avec leurs caractéristiques nominales et effectives, ainsi que en regard le résultat des tests et du diagnostic.

La colonne 1 comprend un identifiant de la batterie utilisée comme repère. Les colonnes 2-5 comprennent les caractéristiques nominales, dans l'ordre : la tension nominale UN, la capacité nominale $C_N$, le courant crête nominal $CCA_N$ et le type, à plaques épaisses, PE ou à plaques minces, PM. La colonne 6 comprend le courant de circuit seuil de régénérabilité $Ic_R$. Les colonnes 7-10 comprennent les caractéristiques effectives, dans l'ordre : la tension effective $U_{eff}$, la résistance effective $R_{eff}$, le courant crête effectif $CCA_{eff}$ et le courant de circuit effectif $Ic_{eff}$. Les colonnes 11-14 comprennent les résultats aux trois tests T1-T3 et le diagnostic global d'aptitude à la régénération.

Le premier test T1 compare la résistance effective $R_{eff}$ à une résistance seuil de régénérabilité de 56 m$\Omega$ pour

les batteries à plaques épaisses 1-11, et à une résistance de 53,2 mΩ pour les batteries à plaques minces 12-20. Les batteries 2, 10-15, 17-20 ne satisfont pas à ce premier test T1. Elles présentent vraisemblablement une dégradation de la matière active et/ou une corrosion des électrodes trop importante.

Le deuxième test T2 compare le courant crête effectif $CCA_{eff}$ à un courant crête seuil de régénérabilité $CCA_R$ pris égal à 200A. Les batteries 1, 2, 19 ne satisfont pas à ce deuxième test T2. Elles présentent vraisemblablement une dégradation de la matière active trop importante.

Le troisième test T3 compare le courant de circuit effectif $Ic_{eff}$ déterminé par $U_{eff}/R_{eff}$ à un courant de circuit seuil de régénérabilité $Ic_R$ pris égal à 193 A, avec $U_R$ = 9, 7V (PM) ou 9, 6V (PE) et $R_R$ = 53,2mΩ (PM) ou 56mΩ (PE). Les batteries 1, 2 ne satisfont pas à ce troisième test T3. Elles présentent vraisemblablement une corrosion des électrodes trop importante.

Il résulte ainsi des trois tests T1-T3 conjoints que les batteries 3-9 et 16 sont seules régénérables.

## Revendications

1. Un procédé de diagnostic d'aptitude à la régénération d'une batterie de type plomb-acide *caractérisé en ce qu'il* comprend la soumission de cette batterie aux trois tests suivants :

   a) un test de l'électrolyte vérifiant que la quantité de sulfate de plomb effective ($m_{PbSO4eff}$) dans les électrolytes de cette batterie est inférieure à la quantité de sulfate de plomb seuil de régénérabilité. ($m_{PbSO4}$),
   b) un test de la matière active, vérifiant que la quantité d'oxyde de plomb effective ($m_{PbOZeff}$) dans les électrolytes de cette batterie est supérieure à la quantité d'oxyde de plomb seuil de régénérabilité ($m_{PbO2R}$),
   c) un test des électrodes, vérifiant que la corrosion des électrodes est inférieure à une corrosion seuil ;
   les trois tests étant réalisés dans l'ordre et chacun de ces tests étant effectué sans avoir à accéder à l'une quelconque des électrolytes de cette batterie, le ou les résultats à ces tests étant utilisé pour poser un diagnostic d'aptitude à la régénération pour cette batterie de type plomb-acide, et où la batterie de type plomb-acide est mise au rebut ou recyclée dès lors qu'un seuil à l'un au moins de ces trois tests a été dépassé.

2. Le procédé selon la revendication **1,** où la quantité de sulfate de plomb ($m_{pbSO4}$) dans la batterie est estimée au regard de sa tension effective ($U_{eff}$) et/ou de sa résistance effective ($R_{eff}$), de préférence au regard de sa résistance effective ($R_{eff}$).

3. Le procédé selon la revendication **2,** où la quantité de sulfate de plomb ($m_{pbSO4}$) est estimée au regard de sa résistance effective ($R_{eff}$) et où la quantité de sulfate de plomb effective ($m_{PbSO4eff}$) dans l'électrolyte de cette batterie est considérée comme inférieure à la quantité de sulfate de plomb seuil de régénérabilité ($m_{PbSO4}$) dès lors que sa résistance effective ($R_{eff}$) est supérieure à 53,2 mΩ pour une batterie 12V à plaques minces (VU et VL), ou à 56 mΩ pour une batterie 12V à plaques épaisses (PL).

4. Le procédé selon l'une quelconque des revendications 1 ou **2,** où la quantité d'oxyde de plomb effective ($m_{pbO2eff}$) dans la batterie est estimée au regard de sa tension effective ($U_{eff}$), de sa résistance effective ($R_{eff}$), de sa capacité effective ($C_{eff}$), de son courant de décharge effectif ($I_{eff}$), ou encore de son courant crête effectif ($CCA_{eff}$), de préférence au regard de son courant crête effectif.

5. Le procédé selon la revendication **4,** où la quantité d'oxyde de plomb effective ($m_{pbO2eff}$) dans une batterie de 12V est estimée au regard de sa de son courant crête effectif ($CCA_{eff}$) et où la quantité d'oxyde de plomb effective ($m_{pbO2eff}$) dans l'électrolyte de cette batterie est considérée comme supérieure à la quantité d'oxyde de plomb seuil de régénérabilité. ($m_{PbO2R}$) dès lors que son courant crête effectif ($CCA_{eff}$) est supérieure à 200 A.

6. Procédé selon l'une quelconque des revendications **1** à **5,** où l'état de corrosion des électrodes est estimé au regard de sa conductance effective ($G_{eff}$) ou de son courant de circuit effectif ($Ic_{eff}$).

7. Procédé selon la revendication **6,** où l'état de corrosion des électrodes d'une batterie de 12V est estimé au regard de son courant de circuit effectif ($Ic_{eff}$) et où l'état de corrosion des électrodes est considéré comme satisfaisant dès lors que son courant de circuit effectif ($Ic_{eff}$) est supérieure à 193 A pour une batterie 12V à plaques minces (VU et VL), ou pour une batterie 12V à plaques épaisses (PL).

**Patentansprüche**

1. Verfahren zur Bestimmung der Regenerationsfähigkeit einer Batterie vom Blei-Säure-Typ, **dadurch gekennzeichnet, dass** es darin besteht, diese Batterie den drei folgenden Tests zu unterwerfen:

   - einem Test des Elektrolyten zur Prüfung, ob die effektive Bleisulfatmenge ($m_{PbSO4eff}$) in den Elektrolyten dieser Batterie niedriger ist, als der Regenerationsfähigkeits-Schwellenwert der Bleisulfatmenge ($m_{PbSO4}$),
   - einem Test der aktiven Masse zur Prüfung, ob die effektive Bleioxidmenge ($m_{PbO2eff}$) in den Elektrolyten dieser Batterie höher ist, als der Regenerationsfähigkeits-Schwellenwert der Bleioxidmenge ($m_{PbO2R}$),
   - einem Test der Elektroden zur Prüfung, ob die Korrosion der Elektroden geringer ist, als ein Korrosions-Schwellenwert,
   wobei die drei Tests in dieser Reihenfolge erfolgen und jeder dieser Tests ausgeführt wird, ohne Zugang auf irgendeinen der Elektrolyten dieser Batterie haben zu müssen, wobei das oder die Ergebnisse dieser Tests verwendet werden, um eine Regenerationsfähigkeitsdiagnose für diese Batterie vom Blei-Säure-Typ zu erstellen und wobei die Batterie vom Blei-Säure-Typ ausgesondert oder wiederaufbereitet wird, sobald ein Schwellenwert in mindestens einem dieser drei Tests überschritten wurde.

2. Verfahren nach Patentanspruch 1, in dem die Bleisulfatmenge ($m_{PbSO4}$) in der Batterie aufgrund ihrer effektiven Spannung ($U_{eff}$) und/oder ihres effektiven Widerstandes ($R_{eff}$) abgeschätzt wird, vorzugsweise aufgrund ihres effektiven Widerstandes ($R_{eff}$).

3. Verfahren nach Patentanspruch 1, in dem die Bleisulfatmenge ($m_{PbSO4}$) aufgrund ihres effektiven Widerstandes ($R_{eff}$) abgeschätzt wird und in dem die effektive Bleisulfatmenge ($m_{PbSO4eff}$) im Elektrolyten dieser Batterie als niedriger, als der Regenerationsfähigkeits-Schwellenwert der Bleisulfatmenge ($m_{PbSO4}$) angesehen wird, sobald ihr effektiver Widerstand ($R_{eff}$) höher ist, als 53,2 m$\Omega$ bei einer 12V-Batterie mit dünnen Platten (Nutzfahrzeug oder PKW) oder als 56 m$\Omega$ bei einer 12V-Batterie mit dicken Platten (LKW).

4. Verfahren nach irgendeinem der Patentansprüche 1 oder 2, in dem die effektive Bleioxidmenge ($m_{PbO2eff}$) in der Batterie aufgrund ihrer effektiven Spannung ($U_{eff}$), ihres effektiven Widerstandes ($R_{eff}$), ihrer effektiven Kapazität ($C_{eff}$), ihrer effektiven Entladungsstromstärke ($I_{eff}$) oder auch ihrer effektiven Spitzenstromstärke ($CCA_{eff}$) abgeschätzt wird, vorzugsweise aufgrund ihrer effektiven Spitzenstromstärke.

5. Verfahren nach Patentanspruch 4, in dem die effektive Bleioxidmenge ($m_{PbO2eff}$) in einer 12V-Batterie aufgrund ihrer effektiven Spitzenstromstärke ($CCA_{eff}$) abgeschätzt wird und in dem die effektive Bleioxidmenge ($m_{PbO2eff}$) im Elektrolyten dieser Batterie als höher, als der Regenerationsfähigkeits-Schwellenwert der Bleioxidmenge ($m_{PbO2R}$) angesehen wird, sobald ihre effektive Spitzenstromstärke ($CCA_{eff}$) höher ist, als 200 A.

6. Verfahren nach irgendeinem der Patentansprüche 1 bis 5, in dem der Korrosionszustand der Elektroden aufgrund ihrer effektiven Leitfähigkeit ($G_{eff}$) oder ihrer effektiven Kreisstromstärke ($IC_{eff}$) abgeschätzt wird.

7. Verfahren nach Patentanspruch 6, in dem der Korrosionszustand der Elektroden in einer 12V-Batterie aufgrund ihrer effektiven Kreisstromstärke ($IC_{eff}$) abgeschätzt wird und in dem der Korrosionszustand der Elektroden als zufriedenstellend angesehen wird, sobald ihre effektive Kreisstromstärke ($IC_{eff}$) höher ist, als 193 A bei einer 12V-Batterie mit dünnen Platten (Nutzfahrzeug oder PKW) oder bei einer 12V-Batterie mit dicken Platten (LKW).

**Claims**

1. A method for diagnosing the regenerative capacity of a lead-acid type battery **characterized in that** it comprises subjecting the battery to the following three tests:

   a) an electrolyte test verifying that the effective amount of lead sulfate (mPbS04eff) in the electrolytes of this battery is less than the amount of lead sulfate regenerability threshold (mPbS04),
   b) a test of the active material, making sure that the effective amount of lead oxide (mPb02eff) in the electrolytes of this battery is higher than the quantity of lead oxide regenerability threshold (mPb02R),
   c) a test electrode, ensuring that the corrosion of the electrodes is less than a threshold corrosion;
   the three tests being carried out in order and each of these tests being performed without having to access any of the electrolytes of the battery, or the results of these tests are used to diagnose aptitude for regeneration for

**EP 2 947 471 B1**

this of lead-acid type battery, and where lead-acid type battery is discarded or recycled when a threshold to at least one of these three tests was exceeded.

2. The method of claim 1, wherein the amount of lead sulfate (mpbS04) in the battery is estimated in relation to its effective voltage (Vrms) and/or to its effective resistance (Reff), preferably in relation to its effective resistance (Reff).

3. The method of claim 2, wherein the amount of lead sulfate (mpbS04) is estimated in relation to its effective resistance (Reff) and wherein the amount of effective lead sulfate (mPbS04eff) in the electrolyte of the battery is considered inferior to the amount of lead sulfate regenerability threshold (mPbS04) since its effective resistance (Reff) is greater than 53.2 mΩ for a 12V battery with thin plates (CV and LV), or 56 mΩ for a 12V battery with thick plates (HV).

4. The method according to any one of claims 1 or 2, wherein the effective amount of lead oxide (mpb02eff) in the battery is estimated in relation to its effective voltage (Vrms), to its effective resistance (Reff), to its effective capacity (Ceff), to its effective discharge current (IRMS), or to is effective peak current (CCAeff), preferably to its effective current peak.

5. The method of claim 4, wherein the effective amount of lead oxide (mpb02eff) in a 12V battery is estimated in relation to its effective current peak (CCAeff) and where the effective amount of lead oxide (mpb02eff) in the electrolyte of the battery is considered as greater than the amount of lead oxide regenerability threshold (mPb02R), when its effective current peak (CCAeff) is greater than 200 A.

6. The method according to any one of claims 1 to 5, wherein the corrosion state of the electrodes is estimated in relation to its effective conductance (Geff) or to its effective circuit current (Iceff).

7. The method of claim 6, wherein the corrosion state of the electrodes of a 12V battery is estimated in relation to its effective circuit current (Iceff) and where the electrode corrosion state is considered satisfactory when its effective circuit current (Iceff) is greater than 193 A for a 12V battery with thin plates (CV and LV) or a 12V battery with thick plates (HV).

14

$$y = 0,0039x^2 - 0,1012x + 0,6681$$

FIG. 1

FIG. 2

FIG. 3

FIG. 3' (modèle pour la détermination du $R_{Reff}$)

FIG. 4

EP 2 947 471 B1

FIG.5'

U = 12,60 V
SOH = 100%

$U_f$ = 10,20 V
SOH = 20%

$U_R$ = 9,60 V
SOH = 1%

Tension de désulfatation
$U_d$ = 11,58 V

Tension seuil de fonctionnement
$U_f$ = 10,20 V

Domaine de tension seuil de régénérabilité
9,6 V ≤ $U_R$ ≤ 9,8 V
200 A ≤ $CCA_R$

$PbO_2/R$

$y = 443,077(0,0039x^2 - 0,1012x + 0,6681)^{-1,002}$

12,60    12,00    11,40    10,80    10,20    9,60    9,00

Tension U (V)

SOH = Etat de santé

FIG. 5

FIG. 6

EP 2 947 471 B1

FIG. 7

EP 2 947 471 B1

| | $U_N$ | $C_N$ | $CCA_N$ | Ty | $Ic_R$ | $U_{eff}$ | $R_{eff}$ | $CCA_{eff}$ | $IC_{eff}$ | T1 | T1 | T3 | Diag |
|---|---|---|---|---|---|---|---|---|---|---|---|---|---|
| 1 | 12 | 100 | 650 | PE | 1,82 | 10,45 | 56,3 | 181 | 17 | OK | NOK | NOK | |
| 2 | 12 | 180 | 1000 | PE | 1,82 | 7,63 | 0 | 26 | ∞ | NOK | NOK | NOK | |
| 3 | 12 | 180 | 1000 | PE | 1,82 | 12,86 | 56,3 | 1050 | 228 | OK | OK | OK | OK |
| 4 | 12 | 180 | 1000 | PE | 1,82 | 12,66 | 56,2 | 950 | 296 | OK | OK | OK | OK |
| 5 | 12 | 180 | 1000 | PE | 1,82 | 12,67 | 56,4 | 1175 | 225 | OK | OK | OK | OK |
| 6 | 12 | 180 | 1000 | PE | 1,82 | 12,67 | 56,5 | 1125 | 224 | OK | OK | OK | OK |
| 7 | 12 | 220 | 1400 | PE | 1,82 | 12,21 | 56,2 | 1125 | 217 | OK | OK | OK | OK |
| 8 | 12 | 220 | 1000 | PE | 1,82 | 12,39 | 56,3 | 1300 | 220 | OK | OK | OK | OK |
| 9 | 12 | 220 | 1000 | PE | 1,82 | 12,38 | 56,4 | 1325 | 220 | OK | OK | OK | OK |
| 10 | 12 | 185 | 1000 | PE | 1,82 | 12,81 | 52,8 | 381 | 243 | NOK | OK | OK | |
| 11 | 12 | 185 | 1000 | PE | 1,82 | 12,87 | 52,9 | 249 | 243 | NOK | OK | OK | |
| 12 | 12 | 88 | 600 | PM | 1,71 | 12,81 | 52,8 | 381 | 243 | NOK | OK | OK | |
| 13 | 12 | 40 | 320 | PM | 1,71 | 12,87 | 52,9 | 249 | 243 | NOK | OK | OK | |
| 14 | 12 | 60 | 540 | PM | 1,71 | 12,86 | 52,9 | 238 | 243 | NOK | OK | OK | |
| 15 | 12 | 55 | 480 | PM | 1,71 | 12,93 | 52,9 | 291 | 244 | NOK | OK | OK | |
| 16 | 12 | 60 | 550 | PM | 1,71 | 13,03 | 53,5 | 605 | 244 | OK | OK | OK | OK |
| 17 | 12 | 55 | 390 | PM | 1,71 | 12,73 | 52,8 | 256 | 241 | NOK | OK | OK | |
| 18 | 12 | 50 | 420 | PM | 1,71 | 13,05 | 53 | 388 | 246 | NOK | OK | OK | |
| 19 | 12 | 50 | 230 | PM | 1,71 | 12,85 | 52,9 | 200 | 243 | NOK | NOK | OK | |
| 20 | 12 | 50 | 600 | PM | 1,71 | 12,92 | 53 | 472 | 244 | NOK | OK | OK | |

FIG. 8

EP 2 947 471 B1

**EP 2 947 471 B1**

## RÉFÉRENCES CITÉES DANS LA DESCRIPTION

**Documents brevets cités dans la description**

- US 20110054815 A
- DE 10103848
- DE 102008056304